## Europäisches Patentamt
## European Patent Office
## Office européen des brevets

(19)

(11) Numéro de publication: **0 267 062 B1**

(12) # FASCICULE DE BREVET EUROPEEN

(45) Date de publication du fascicule du brevet:
24.10.90

(51) Int. Cl.⁵: **G01N 24/08**

(21) Numéro de dépôt: 87402101.7

(22) Date de dépôt: 21.09.87

(54) Procédé de mesure des paramètres de diffusion moléculaire et/ou de perfusion d'un tissu vivant.

(30) Priorité: 26.09.86 FR 8613483

(43) Date de publication de la demande:
11.05.88 Bulletin 88/19

(45) Mention de la délivrance du brevet:
24.10.90 Bulletin 90/43

(84) Etats contractants désignés:
DE GB NL

(56) Documents cités:
EP-A- 0 132 975
US-A- 4 413 233
US-A- 4 602 641

PHYSICS IN MEDICINE & BIOLOGY,
vol. 30, no. 4, 1985, pages 345-349, The Institute of
Physics, Bristol, GB; D.G. TAYLOR et al.: " The spatial
mapping of translational diffusion coefficients by the
NMR imaging technique"
COMPTES RENDUS.SERIE C.SCIENCES CHIMIQUES,
vol. 301, no. 15, novembre 1985, pages 1109-1112, Académie des Sciences, Paris, FR; D. LE BIHAN et al.:
"Résonance magnétique - Imagerie de diffusion in vivo
par résonance magnétique nucléaire"
SIEMENS ELECTRO MEDICA,
vol. 54, no. 1, 1986, pages 3-14, Erlangen, DE; A.

(73) Titulaire: GENERAL ELECTRIC-CGR S.A., 100, rue
Camille-Desmoulins, F-92130 Issy les Moulineaux(FR)

(72) Inventeur: Breton, Eric, THOMSON-CSF SCPI 19, avenue
de Messine, F-75008 Paris(FR)
Inventeur: Le Bihan, Denis, THOMSON-CSF
SCPI 19, avenue de Messine, F-75008 Paris(FR)

(74) Mandataire: Ballot, Paul Denis Jacques, Cabinet
Ballot-Schmit 7, rue le Sueur, F-75116 Paris(FR)

(56) Documents cités: (suite)
GANSSEN et al.: "Stand und Zukunftsperspektiven der
Kernspintomographie in der medizinischen Diagnostik"

**Description**

La présente invention a pour objet un procédé de mesure des paramètres de diffusion moléculaire et/ou de perfusion d'un tissu vivant. Dans ce but le tissu est soumis à une expérimentation de résonance magnétique nucléaire (RMN). L'invention trouve plus particulièrement son application dans le domaine médical où de telles expérimentations sont entreprises à des fins de diagnostic chez l'homme. Elle peut bien entendu être aussi utilisée sur des animaux. Elle est plus particulièrement mise en oeuvre en association avec des méthodes de mise en image du paramètre mesuré. Les principaux paramètres mesurés sont la constante de diffusion moléculaire et/ou le pourcentage de capilaires perfusés, et leurs mesures en sont principalement effectuées dans le cerveau.

Au cours d'un examen de RMN, un corps examiné est soumis à l'influence d'un champ magnétique orientateur, constant, intense et homogène. Sous cette influence les moments magnétiques des atomes de ce corps s'orientent avec ce champ. Puis, pendant qu'il est soumis à ce champ, une excitation électromagnétique radiofréquence lui est appliquée de manière à faire basculer l'orientation des moments magnétiques de ses atomes. A la fin de ce basculement, lorsque l'excitation cesse, les moments magnétiques tendent à se réaligner avec le champ constant en émettant un signal radiofréquence. Ce signal dépend de l'intensité du champ et de la nature des particules excitées : la plupart du temps des protons de l'atome d'hydrogène. Le signal émis est capté et est traité, en particulier de manière à extraire des images représentatives de coupes du corps ainsi étudié.

Au cours du traitement il est possible de discriminer des paramètres particuliers des tissus. D'une manière classique il est connu de discriminer la densité des protons excités et les temps de relaxation, spin - spin et spin -réseau, de ces protons avec la matière environnante. Il est aussi connu de chercher à représenter la constante de diffusion moléculaire des protons concernés ainsi que la perfusion. La constante de diffusion moléculaire mesure l'aptitude qu'ont les protons en question de se déplacer légèrement de part et d'autre de leur position d'équilibre dans les atomes du tissu auxquels ils appartiennent. Cette mesure de diffusion moléculaire est particulièrement recherchée car elle permet de prendre des décisions thérapeutiques, selon le résultat, alors que la mesure des temps de relaxation ne permet pas toujours de bien caractériser les tissus malades, par exemple ceux atteints du cancer. La perfusion rend compte de l'état de vascularisation du tissu.

La mesure de la constante de diffusion moléculaire nécessite, en particulier selon l'enseignement d'une demande de brevet français déposée par le demandeur le 27 JUIN 1985 sous le n o 85 09824, EP-A 20 860 d'exécuter deux expérimentations, deux séries de mesures. Au cours d'une première série de mesures, dite peu diffusante, on rélève les signaux radiofréquences d'une manière classique. Au cours d'une deuxième série, dite diffusante, on applique pendant l'expérimentation des suppléments de champ constant, distribués avec une variation linéaire (gradient) dans le volume du tissu étudié, de manière à altérer le signal radiofréquence résultant. Cette altération est fonction du déplacement subi par les protons au cours de l'expérimentation : elle est caractéristique de leur constante de diffusion moléculaire. Par une comparaison des résultats obtenus à l'issue de la première série, à ceux obtenus à l'issue de la deuxième série, on peut extraire la constante de diffusion en chaque point du tissu étudié. La mesure de perfusion est une amélioration de la méthode. Elle est décrite dans la demande de brevet européen du demandeur déposée le 27 juin 1986 sous le numéro 86 401423.8. On y exécute une troisième série de mesures, a vec un effet diffusant, différent de celui de la deuxième série. Par une comparaison des résultats obtenus à l'issue de la première série à ceux obtenus à l'issue de la troisième on peut aussi extraire la constante de diffusion en chaque point du tissu étudié. Par comparaison des deux extractions on peut déduire le pourcentage de capilaires perfusés.

D'autres techniques de mesure de la constante de diffusion moléculaire sont cependant également envisageables. On en trouve par exemple une description dans un article dû à Messieurs WESBEY George et al, intitulé "TRANSLATIONAL MOLECULAR SELF-DIFFUSION IN MAGNETIC RESONANCE IMAGING : EFFECTS AND APPLICATION", dans la revue Biomédical Magnetic Resonance éditée en 1984 par Radiology Research and Education Fundation (San Francisco). Cet article suggère de mesurer la constante de diffusion d'un tissu en comparant l'effet relatif de la diffusion dans ce tissu et dans un corps étalon lors de séries de séquences d'excitation différentes.

Quelle que soit la méthode employée, on a pu observer que malgré toutes les précautions prises la précision des mesures, ou la netteté des images, n'étaient pas parfaites. On a tenté d'attribuer ces défauts aux appareils servant à appliquer les gradients. On a pensé qu'au cours des expérimentations ces appareils n'étaient pas stables et ne permettaient pas de soumettre les tissus étudiés à des contraintes comparables, de sorte que ces tissus restituent des signaux qui évoluent au cours des séries d'excitations radiofréquences. On a aussi pensé que la nature même des tissus examinés, des tissus humains vascularisés , pouvaient être la cause de ces défauts. En particulier des turbulences d'écoulement du sang dans les capillaires pouvaient provoquer des artefacts susceptibles de troubler les images.

En fait, dans l'invention, on a remarqué que les vaisseaux sanguins et les tissus environnants, de même que le cerveau tout entier, sont animés de mouvements, en synchronisme avec les battements cardiaques, suffisants pour introduire des artefacts importants dans les séquences d'imagerie de diffusion et/ou de perfusion. On a alors remédié à ces problèmes d'une manière particulièrement simple et efficace. On a synchronisé l'application des excitations radiofréquence, et d'une manière correspondante la mesure des signaux captés, avec le battement cardiaque du patient. En synchronisant on s'est assuré d'effectuer la saisie des signaux toujours dans les mêmes conditions. Il en a résulté une amélioration immédiate et très sensible des résultats enregistrés. Les images de diffusion moléculaire deviennent nettes, permettent de prendre des décisions sûres en précisant les contours et l'ampleur des zones atteintes.

L'invention concerne un procédé de mesure des paramètres de diffusion moléculaire et/ou de perfusion d'un tissu vivant d'un patient au moyen d'une expérimentation de RMN, comportant au moins une série de séquences excitation radiofréquence de ce tissu, caractérisé en ce qu'on synchronise les excitations sur le rythme cardiaque du patient.

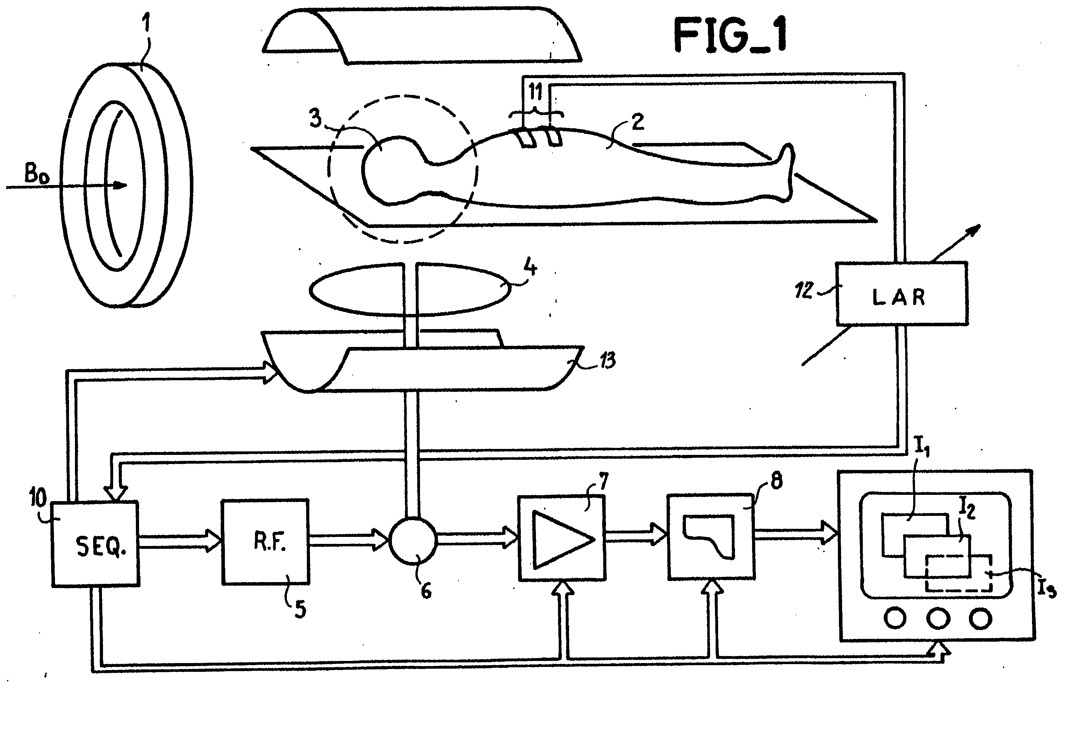

L'invention sera mieux comprise à la lecture de la description qui suit et à l'examen de la figure qui l'accompagne. Celles ci ne sont données qu'à titre indicatif et nullement limitatif de l'invention. La figure 1 unique montre schématiquement une machine utilisable pour la mise en oeuvre du procédé selon l'invention.

La figure 1 montre ainsi une machine de RMN comportant des moyens 1 pour soumettre un corps à étudier 2 à un champ magnétique, homogène, constant, et intense $B_0$. Dans un exemple particulier le corps 2 est celui d'un patient, et on cherche, dans un exemple particulier à représenter les phénomènes qui se produisent dans son cerveau 3. La machine comporte de plus une antenne radioélectrique 4 reliée à un émetteur d'excitations radiofréquences 5 pour faire basculer l'orientation des moments magnétiques des protons du corps 2. L'antenne 4 peut également servir à prélever le signal de désexcitation restitué par ces protons à l'issue des excitations. Au moyen d'un duplexeur 6, le signal capté est acheminé sur des moyens 7 de réception et de mesure. Le signal mesuré est ensuite traité dans des moyens de traitement 8. Ces derniers peuvent éventuellement être en relation avec des moyens 9 de visualisation d'une coupe d'une partie 3 du corps 2 examiné. Ensemble, ces moyens sont connus et fonctionnent d'une manière classique sous le commandement d'un séquenceur 10. Au cours des séquences, des codages supplémentaires sont appliqués par des moyens de codage comportant notamment des bobines 13 dites de gradient.

Dans un exemple d'experimentation envisagé le corps 2 est soumis à au moins deux séries d'excitations. Au cours d'une première série d'excitations, dite peu diffusante, on acquiert d'une manière classique une image $I_1$ de la partie concernée du corps 2. Au cours d'une deuxième série d'excitations, dite diffusante, on acquiert une deuxième image dite $I_2$ des mêmes parties du corps 2. Au cours des deux séries d'excitations les caractéristiques des séquences excitation sont semblables, sauf l'adjonction aux cours des excitations diffusantes, d'impulsions supplémentaires et bipolaires de gradient de champ constant. Si chaque séquences de ces séries comporte plusieurs excitations à écho de spin leur nombre peut éventuellement être différent d'une série à l'autre. A part cette différence les deux images $I_1$ et $I_2$ sont acquises dans les mêmes conditions, en particulier la durée de chaque phase d'excitation-mesure de chaque série est exactement la même, le nombre des excitations dans chaque série et le même, et le temps de répétition qui sépare les séquences d'excitation successives dans une série est le même dans les deux séries. Si $S_1$ et $S_2$ sont des résultats des mesures, représentatives en un même point des images respectivement $I_1$ et $I_2$, on a pu établir, dans la demande de brevet précitée, que la constante de diffusion moléculaire relative à ce point était proportionelle au logarithme du rapport $S_2/S_1$. Le coefficient de proportionalité dépend uniquement de l'allure des gradients supplémentaires au cours des séquences d'excitation diffusantes.

Ce qui caractérise la présente invention est que, pour chaque séquence de chaque série de l'expérimentation, le séquenceur initialise l'excitation en synchronisme avec le battement cardiaque du patient 2. A cette fin un détecteur 11 de ce battement cardiaque est relié à une entrée de synchronisation du séquenceur 10. Le cycle cardiaque étant ainsi pris en compte il est possible de se synchroniser, en particulier au moyen d'une ligne à retard réglable 12, par rapport à n'importe quelle date de ce cycle cardiaque. D'une manière préférée on s'arrange pour déclencher les excitations, et leur mesure au bout d'un temps constant dependant de la forme de l'excitation retenue, à des instants où le tissu à imager, le cerveau, est le plus immobile possible. Ainsi on s'affranchit de la variation correspondante du paramètre mesuré : les images $I_3$ obtenues par comparaisons des images $I_1$ aux images $I_2$ sont alors dépourvues d'artefact. L'invention est bien entendu applicable à tous les autres procédés de mesure de la constante de diffusion moléculaire ainsi qu'aux procédés de mesure de la perfusion sanguine. Autrement dit, dès qu'il y a des séries d'excitation il faut synchroniser les excitations.

## Revendications

1. Procédé de mesure des paramètres de diffusion moléculaire d'un cerveau (3) vivant d'un patient (2) au moyen d'une expérimentation de RMN (1-10), comportant au moins une série de séquences d'excitation (4-5) radiofréquence de ce cerveau, caractérisé en ce que l'on synchronise (11) les excitations sur le rythme cardiaque du patient.

2. Procédé de mesure du paramètre de perfusion d'un cerveau vivant d'un patient au moyen d'une expérimentation de RMN, comportant au moins une série de séquences d'excitation radiofréquence de ce coneau, caractérisé en ce qu'on synchronise les excitations sur le rythme cardiaque du patient.

3. Procédé de mesure des paramètres de diffusion moléculaire et de perfusion d'un cerveau vivant d'un patient au moyen d'une expérimentation de RMN, comportant au moins une série de séquences d'excitation radiofréquence de ce coneau, caractérisé en ce qu'on synchronise les excitations sur le rythme cardiaque du patient.

4. Procédé selon l'une quelconque des revendications 1 à 3 caractérisé en ce que la mesure comporte une mise en image (9) des paramètres.

5 - Procédé selon l'une quelconque des revendications 1 à 4, caractérisé en ce qu'un des paramètres est la constante de diffusion moléculaire.

6 - Procédé selon l'une quelconque des revendications 1 à 5, caractérisé en ce que le cerveau est le cerveau du cerveau du patient.

7 - Procédé selon l'une quelconque des revendications 1 à 6 caractérisé, en ce que l'on synchronise les excitations sur des instants choisis (12) du rythme cardiaque du patient.

8 - Procédé selon l'une quelconque des revendications 1 à 7 caractérisé en ce qu'à l'issue d'une première et d'une deuxième série de séquences d'excitation on acquiert une première ($I_1$) et une deuxième ($I_2$) image, les deux séries étant différenciées par la modification, au cours de la deuxième, d'une caractéristique de l'expérimentation, les paramètres de diffusion moléculaire étant déduit dans une troisième ($I_3$) image des comparaisons point à point des deux premières images.

## Patentansprüche

1. Verfahren zur Bestimmung der molekularen Diffusionsparameter des Gehirns (3) eines Patienten (2) mittels eines NMR-Experiments (1 bis 10), mit wenigstens einer ersten und einer zweiten Reihe von Folgen von Radiofrequenzerregungen (4, 5) dieses Gehirns, dadurch gekennzeichnet, daß die Erregungen in ausgewählten Momenten (12) des Herzrhythmus dieses Patienten, in denen das Gehirn so wenig aktiv wie möglich ist, mit dem Herzrhythmus synchronisiert (11) werden.

2. Verfahren zur Bestimmung des Durchblutungsparameters des Gehirns eines Patienten mittels eines NMR-Experiments, mit wenigstens einer ersten und einer zweiten Reihe von Folgen von Radiofrequenzerregungen dieses Gehirns, dadurch gekennzeichnet, daß die Erregungen in ausgewählten Momenten (12) des Herzrhythmus dieses Patienten, in denen das Gehirn so wenig aktiv wie möglich ist, mit dem Herzrhythmus synchronisiert werden.

3. Verfahren zur Bestimmung der molekularen Diffusionsparameter und des Durchblutungsparameters des Gehirns eines Patienten mittels eines NMR- Experiments, mit wenigstens einer ersten und einer zweiten Reihe von Folgen von Radiofrequenzerregungen dieses Gehirns, dadurch gekennzeichnet, daß die Erregungen in ausgewählten Momenten (12) des Herzrhythmus dieses Patienten, in denen das Gehirn so wenig aktiv wie möglich ist, mit dem Herzrhythmus synchronisiert werden.

4. Verfahren gemäß einem der Ansprüche 1 bis 3, dadurch gekennzeichnet, daß die Bestimmung eine bildliche Darstellung (9) der Parameter umfaßt.

5. Verfahren gemäß einem der Ansprüche 1 bis 4, dadurch gekennzeichnet, daß einer der Parameter die Konstante der molekularen Diffusion ist.

6. Verfahren gemäß einem der Ansprüche 1 bis 5, dadurch gekennzeichnet, daß bei der Ausgabe der ersten und der zweiten Reihe der Folgen von Erregungen ein erstes ($I_1$) und ein zweites ($I_2$) Bild erhalten wird, wobei die zwei Reihen durch die Abwandlung eines Merkmals des Experiments während der Ausgabe der zweiten Reihe voneinander unterschieden werden und wobei die molekularen Diffusionsparameter in einem dritten ($I_3$) Bild, das sich aus dem punktweisen Vergleich der beiden ersten Bilder ergibt, hergeleitet werden.

## Claims

1. A method for the measurement of the parameters of molecular diffusion of the brain (3) of a patient (2) by means of NMR investigations (1 through 10) comprising at least and a first and a second series of radio frequency excitation sequences (4 and 5) of the said bain, characterized in that the excitation is synchronized (11) with the cardiac rhythm of the patient at selected instants (12) of the cardiac rhythm of the patient when the brain is as immobile as possible.

2. A method for the measurement of the parameter of perfusion of the brain of a patient by means of NMR investigations, comprising at least a first and a second series of radio frequency excitation sequences of the said brain, characterized in that the said excitation is synchronized with the cardiac rhythm of the patient at selected instants (12) of the cardiac rhythm when the brain is as immobile as possible.

3. A method for the measurement of the parameters of molecular diffusion and of perfusion of the brain of a patient by means of NMR investigations, comprising at least a first and a second series of radio frequency excitation sequences of the said brain, characterized in that the said excitation is synchronized with the cardiac rhythm of the patient at selected instants (12) of the cardiac rhythm when the brain is as immobile as possible.

4. The method as claimed in any one of the preceding claims 1 through 3, characterized in that the said measurement comprises the production of an image (9) of the parameters.

5. The method as claimed in any one of the preceding claims 1 through 4, characterized in that one of said parameters is the constant of molecular diffusion.

6. The method as claimed in any one of the preceding claims 1 through 5, characterized in that as the outcome of the first and of the second series of excitation a first ($I_1$) and a second ($I_2$) image is produced, the two series differing from each other by the modification, during the course of the second one, of one characteristic of the investigation, the parameters of diffusion being deduced in a third image ($I_3$) of dot by dot comparison of the two first images.

FIG_1